Europäisches Patentamt

European Patent Office

Office européen des brevets

(11) Publication number: **0 075 875**
A2

# (12) EUROPEAN PATENT APPLICATION

(21) Application number: 82108820.0

(22) Date of filing: 24.09.82

(51) Int. Cl.³: **H 01 L 21/314**
H 01 L 21/32, H 01 L 21/76

(30) Priority: 28.09.81 US 305883

(43) Date of publication of application:
06.04.83 Bulletin 83/14

(84) Designated Contracting States:
DE FR GB IT NL

(71) Applicant: GENERAL ELECTRIC COMPANY
1 River Road
Schenectady New York 12305(US)

(72) Inventor: Ghezzo, Mario
79 Blue Spruce Lane
Ballston Lake New York 12019(US)

(72) Inventor: McConnelee, Paul Alan
1222 Palma Avenue
Schenectady New York 12306(US)

(74) Representative: Sieb, Rolf, Dr. et al,
European Patent Attorney Kaiserstrasse 41
D-6000 Frankfurt (Main) 1(DE)

(54) Method of making integrated circuits comprising dielectric isolation regions.

(57) A method of reducing lateral field oxidation in the vicinity of the active regions of a silicon substrate in which integrated circuit elements are to be formed is described. The method utilizes a first thin layer of silicon dioxide in contact with the active region of the substrate and a second thick layer of silicon nitride overlying the thin layer of silicon dioxide. The thin layer of silicon dioxide is provided with peripheral portions constituted of a silicon oxynitride.

FIG. 1

10136-RD-11155

- 1 -

## METHOD OF MAKING INTEGRATED CIRCUITS

The present invention relates to improvements in methods of making integrated circuits.

Such circuits include a plurality of active components electrically isolated on a common silicon substrate. In the making of such circuits the active regions of the substrate on which the active components are formed are masked by a thin layer of silicon dioxide on which is formed a thicker layer of silicon nitride. The layer of silicon nitride serves as a mask for etching exposed portions of the layer of silicon dioxide and also for etching a recess in the silicon substrate and for the subsequent oxidation of the silicon in the recess to form the thick field oxide which provides electrical isolation of the active components. The thin layer of silicon dioxide covering the active region of the substrate is provided to buffer the thermal expansion mismatch between the silicon substrate and the silicon nitride masking layer.

In the oxidation step lateral diffusion of oxygen through the thin layer of oxide causes growth of oxide in the outer portions of the surface of the active region and produces a lateral protrusion of oxide referred to in the art as the "bird's beak" formation. The "bird's beak" formation represents a transition region of silicon dioxide between the edge of an active region of reduced surface dimensions to the edge of the field oxide region. With "bird's beak" formations, curvature is also produced in the surfaces of the active regions. Thus, the "bird's beak" formations results not only in shifting the edge of the active region but also results in a substantial reduction in usable surface of the substrate for the fabrication of active components thereon.

An object of the present invention is to provide a method for substantially eliminating "bird's beak" formations in the fabrication of integrated circuits.

Another object of the present invention is to provide a relatively simple method of forming active regions of improved planarity and increased density in integrated circuits.

In carrying out the method of the present invention in accordance with one embodiment thereof, a substrate of semiconductor material of one conductivity type having a major surface is provided. A thin layer of silicon dioxide is formed on the major surface. A thick layer of silicon nitride is formed over the layer of silicon dioxide. The layer of silicon nitride is patterned to produce a retained portion overlying and in registry with an active region of the major surface. The patterned layer of silicon nitride is utilized

- 3 -    **0075875**

to pattern the layer of silicon dioxide to produce a retained portion overlying and in registry with the active region of the major surface thereby exposing the major surface of the substrate surrounding the active region.  The exposed portion of the major surface of the silicon substrate is etched to a first depth to form a moat surrounding the active region.  The peripheral regions of the retained portion of the aforementioned layer of silicon dioxide is converted into a silicon oxynitride.  The substrate is then heated in an oxidizing atmosphere to a temperature and for a time to cause the silicon semiconductor material surrounding the active region to be converted to silicon dioxide.  The retained portion of the layer of silicon nitride and retained portion of the layer of silicon dioxide overlying the active region are then removed.

The novel features which are believed to be characteristic of the present invention are set forth with particularity in the appended claims.  The invention itself, both as to its organization and method of operation, together with further objects and advantages thereof may best be understood by reference to the following description taken in connection with the accompanying

drawings wherein:

Figure 1 is a plan view of a composite body representing a section of an integrated circuit showing a silicon substrate on which is formed a single active region surrounded by an isolating layer of thick silicon dioxide.

Figure 2 is a cross sectional view of the section of the substrate of Figure 1 taken along section lines 2-2 thereof.

Figures 3A-3F show cross sections of structures representing successive steps in one method of fabricating the composite structure of Figure 1 in accordance with the present invention.

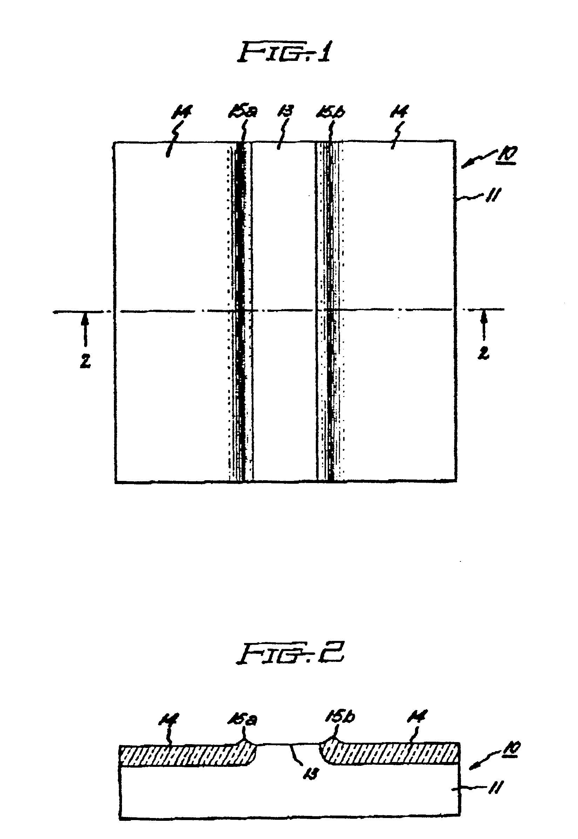

Referring now to Figures 1 and 2, there is shown a composite body 10 representing a section of an integrated circuit made in accordance with the present invention. The composite body 10 includes a substrate 11 of silicon having a major surface 12 in which is provided an active region 13 surrounded by a dielectrically isolating layer of thick silicon dioxide 14. Active components of devices such as field effect (not shown) transistors are formed in the active region and are isolated from other such active components formed on the substrate by the dielectrically isolating layer of thick silicon dioxide 14. The particular features of the structure are that the surface portion of the active region 13 retains its size and location on the substrate essentially as assigned prior to the processing of the substrate with minimum shrinkage thereof due to the processing of the substrate to form the dielectric isolating layer in accordance with the present invention. Minimizing the formation of "bird's beak" enables the planarity of the active region to be maintained as desired. Figure 2 shows protrusions 15a and 15b in the thick oxide layer representing the head formations incident to "bird's beak" formation.

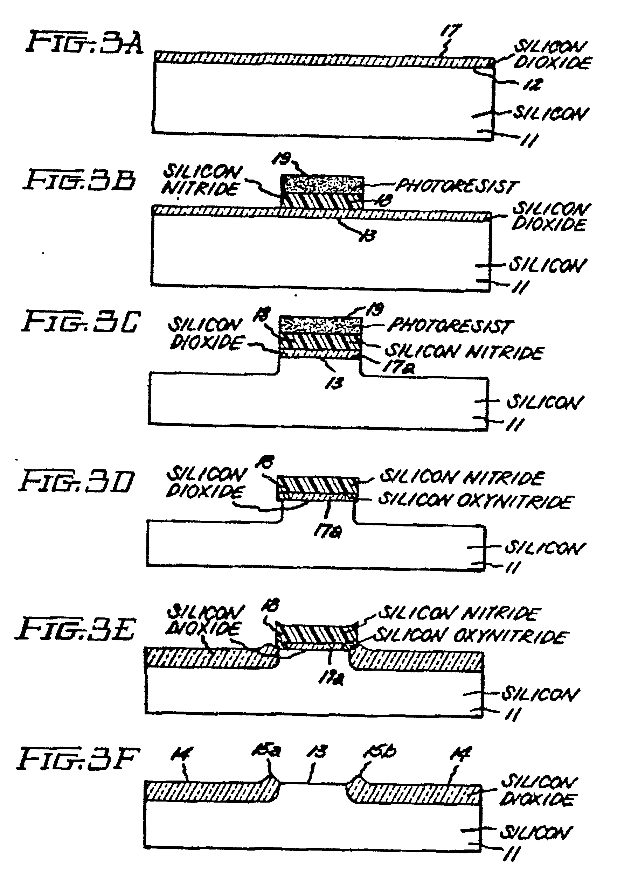

A method of fabricating the composite structure of Figures 1 and 2 in accordance with the present invention will now be described in connection with Figures 3A-3F. Elements of Figures 3A-3F identical to elements of Figures 1 and 2 are identically designated. A substrate 11 of silicon semiconductor material of 4 ohm-cm resistivity and P-type conductivity having a major surface 12 parallel to a (100) plane of the substrate is provided. A thin layer 17 of silicon dioxide about 300 Angstroms thick is formed on the major surface 12 by exposing the silicon substrate to an ambient of oxygen at a temperature of about 1000°C for a period of 30 minutes, as shown in Figure 3A. Thereafter, a layer of silicon nitride is deposited on the surface of the thin layer of silicon dioxide by chemical vapor deposition. In this process vapors of silane and ammonia in the ratio of 1 to 200 by volume in hydrogen carrier are utilized at a temperature of 1000°C and for a time of 20 minutes to form a layer of silicon nitride about 2000 Angstroms thick. The layer of silicon nitride is then patterned to provide a retained portion 18 which overlies and is in registry with the active region 13 of the substrate. The layer of silicon nitride is patterned by techniques well known in the art, for example, by providing a patterned layer 19 of a suitable photoresist thereon and removing the portions thereof unprotected by photoresist by plasma etching using carbon tetrafluoride with 4%

- 6 -

**0075875**

oxygen. The resultant structure is shown in Figure 3B. Thereafter, the thin layer of silicon dioxide unmasked by the retained portion of silicon nitride is etched using a suitable etch such as buffered hydro- fluoride acid to provide retained portion 17a thereof. The surface portion of the substrate underlying the unmasked portions of the thin layer of silicon dioxide is reactive ion etched to a predetermined depth utilizing a suitable etchant such as carbon tetrachloride, as shown in Figure 3C. The depth of etch of the silicon substrate is selected such that on subsequent regrowth of silicon dioxide in the moats or etched out portions the silicon dioxide is sufficiently thick to provide a surface thereof substantially coplanar with the surface of the active region. To attain such a condition the etch depth is set to approximately 57% of the resultant thickness of the silicon dioxide layer. After removal of the pattern layer 19 of photoresist, the substrate is subjected to high temperature annealing in dry ammonia in a nitrogen carrier. This is done at a temperature of $1000^{o}C$ and for a time of one hour to provide sufficient conversion of the peripheral parts of the retained portion of layer 17 of silicon dioxide to a silicon oxynitride, i.e. a binary system of silicon dioxide and silicon nitride, as shown in Figure 3D. Silicon oxynitride provides a better barrier to the diffusion of oxygen therethrough than does silicon dioxide. By making such a portion sufficiently thick, for example, 500 Angstroms, a very substantial portion of oxygen diffusion therethrough is blocked thereby inhibiting the conversion of the surface portions of the active region of the substrate to silicon dioxide and producing the "bird's beak" formation. While the exposed surface of the silicon substrate is converted to a thin layer of silicon nitride during the formation of the oxynitride on the peripheral portions of silicon dioxide layer 17, such layer of silicon nitride is quite thin, for example, of the order of 50 Angstroms. In the next step of the process, the substrate is heated in an oxidizing atmosphere to a temperature and for a time to cause the silicon semiconductor material including the thin layer of silicon nitride formed thereon and surrounding the active region, that is, in the etched out portions, to be converted to silicon dioxide 14 as shown in Figure 3E. Thereafter, the retained portion of silicon nitride and the portions of the silicon oxynitride remaining on the layer 17 are removed in boiling phosphoric acid. The underlying retained portion of the layer 17 of silicon dioxide is removed utilizing a suitable etch such as buffered hydrofluoric acid, as shown in Figure 3F. At this point in the process, active devices or components such as field effect transistors may be readily formed in the active regions.

While the silicon substrate unmasked by the retained portion 17a of the thin layer of silicon dioxide and the retained portion 18 of the layer of silicon nitride was etched prior to oxidation of the substate to form the thick field oxide 14, this step could be eliminated, if desired, with the result that the surface of the active region 13 and the outer surface of the field oxide 14 would be less planar.

While the invention has been described in a specific embodiment, it will be understood that modifications, such as those described above, may be made by those skilled in the art and it is intended by the appended claims to cover all such modifications and changes as fall within the true spirit and scope of the invention.

CLAIMS:

1. The method of providing in a substrate of semiconductor material of one conductivity type having a major surface, an active region which is surrounded by a thick layer of silicon dioxide,

providing said substrate of silicon semiconductor material of one conductivity type having a major surface including said active region,

forming a thin layer of silicon dioxide on said major surface,

forming a thick layer of silicon nitride on said layer of silicon dioxide,

patterning said layer of silicon nitride to produce a retained portion thereof overlying and in registry with said active region of said surface,

patterning said layer of silicon dioxide to produce a retained portion thereof overlying and in registry with said active region of said major surface thereby exposing said major surface surrounding said active region,

converting the peripheral portions of said retained portion of said layer of silicon dioxide into a silicon oxynitride,

heating said substrate in an oxidizing atmosphere to a temperature and for a time to cause the silicon semiconductor material surrounding said active region to be converted to silicon dioxide,

removing said retained portion of said layer of silicon nitride and said retained portion of said layer of silicon dioxide overlying said active region.

2.    The combination of claim 1 in which prior to heating said substrate in an oxidizing atmosphere, the exposed portion of said silicon substrate is etched to a first depth to form a moat therein surrounding said active region.

3.    The combination of claim 2 in which said first depth is approximately 57% of the thickness of silicon oxide to be formed thereon by said heating step whereby the surfaces of said active region and thermally grown layer of silicon dioxide are substantially coplanar.

4.    The combination of claim 1 in which said substrate and said retained portion of said layer of silicon dioxide are exposed to an atmosphere of dry ammonia in a nitrogen carrier at a temperature of about 1000°C and for a time to convert an appreciable lateral portion of said retained portion of said layer of silicon dioxide to a silicon oxynitride.

5.    The combination of claim 4 in which said appreciable lateral portion is greater than about 500 Angstroms.

*FIG.1*

*FIG.2*

FIG.3A

*17*  SILICON DIOXIDE
*12*
SILICON
*11*

FIG.3B

SILICON NITRIDE  *19*  PHOTORESIST
*18*  SILICON DIOXIDE
*13*
SILICON
*11*

FIG.3C

SILICON DIOXIDE  *18*  *19*  PHOTORESIST
SILICON NITRIDE
*17a*
*13*
SILICON
*11*

FIG.3D

SILICON DIOXIDE  *18*  SILICON NITRIDE
SILICON OXYNITRIDE
*17a*
SILICON
*11*

FIG.3E

SILICON DIOXIDE  *18*  SILICON NITRIDE
SILICON OXYNITRIDE
*17a*
SILICON
*11*

FIG.3F

*14*  *15a*  *13*  *15b*  *14*
SILICON DIOXIDE
SILICON
*11*